# EUROPÄISCHE PATENTSCHRIFT

(11) **EP 3 396 713 B1**
(45) Veröffentlichungstag und Bekanntmachung des Hinweises auf die Patenterteilung: **29.04.2020**
(21) Anmeldenummer: 18178573.4
(22) Anmeldetag: 21.03.2013
(51) Int. Cl.: H01L 25/075, B41J 2/45, H01L 33/58, B41F 23/04, F21V 13/04, G02B 3/06, F21K 9/60, F21V 5/04

(54) **LEUCHTE MIT LEDS UND ZYLINDERLINSE**
LIGHT WITH LEDS AND CYLINDRICAL LENS
DISPOSITIF D'ÉCLAIRAGE À LED ET À LENTILLE CYLINDRIQUE

(30) Priorität: 02.05.2012 DE 102012008638
(43) Veröffentlichungstag der Anmeldung: 31.10.2018
(62) Teilanmeldung aus: 13715889.5
(73) Patentinhaber: Heraeus Noblelight GmbH, 63450 Hanau (DE)
(72) Erfinder: Peil, Michael, 64853 Otzberg (DE); Schadt, Susanne, 63505 Langenselbold (DE); Maiweg, Harald, 41352 Korschenbroich (DE)
(74) Vertreter: Herzog IP Patentanwalts GmbH

(56) Entgegenhaltungen:
- EP-A1- 0 625 846
- EP-A1- 1 403 077
- US-A1- 2011 198 619

## Beschreibung

Die Erfindung betrifft eine Leuchte, umfassend zumindest ein Modul mit einer Mehrzahl von über eine Modulfläche verteilten LEDs, wobei in einer Längsrichtung des Moduls mehrere LEDs in einer Reihe angeordnet sind, und wobei in einer zu der Längsrichtung senkrechten Querrichtung des Moduls mehrere der Reihen nebeneinander angeordnet sind, und wobei die LED-Leuchte eine Optik zur Bündelung des von den LEDs emittierten Lichts umfasst. Ferner umfasst die Optik zumindest eine erste, in der Längsrichtung erstreckte Zylinderlinse, wobei das Licht zumindest einiger der LEDs einer ersten der Reihen mittels der ersten Zylinderlinse in eine Linie auf einer Zielfläche gebündelt wird.

WO 2012/031703 A1 beschreibt ein Herstellungsverfahren für Chip-On-Board-Module, bei denen ein Substrat einen plattenförmigen Träger mit mehreren LEDs umfasst, wobei eine Oberfläche des Substrats in einer offenen Gießform überdeckend mit einer Schicht zur Ausbildung einer Optik versehen wird.

Im Stand der Technik lehrt EP 1 403 077 A1 ferner eine Vorrichtung, insbesondere eine Abtasteinrichtung, zum zeilenförmigen Beleuchten einer Oberfläche mit Licht unterschiedlicher Wellenlängen.

Es ist die Aufgabe der Erfindung, eine LED-Leuchte anzugeben, mit der eine homogene Bestrahlungsdichte in einer definierten Struktur erzielbar ist.

Diese Aufgabe wird gelöst durch eine Leuchte, umfassend
zumindest ein Modul mit einer Mehrzahl von über eine Modulfläche verteilten LEDs,
wobei in einer Längsrichtung des Moduls mehrere LEDs in einer Reihe angeordnet sind, und
wobei in einer zu der Längsrichtung senkrechten Querrichtung des Moduls mehrere der Reihen nebeneinander angeordnet sind,
und wobei die LED-Leuchte eine Optik zur Bündelung des von den LEDs emittierten Lichts umfasst,
wobei die Optik zumindest eine erste, in der Längsrichtung erstreckte Zylinderlinse umfasst,
wobei das Licht zumindest einiger der LEDs einer ersten der Reihen mittels der ersten Zylinderlinse in eine Linie auf einer Zielfläche gebündelt wird,

dadurch gekennzeichnet, dass wenigstens 50% des von den LEDs emittierten Lichtes in einem Wellenlängenbereich von weniger als 470nm liegen.

Durch die Verwendung einer über zumindest mehrere LEDs durchgehend erstreckte Zylinderlinse lässt sich effektiv und mit wenigen Bauteilen eine homogene Bündelung des Lichtes der einzelnen LEDs erzielen.

Unter einem Modul im Sinne der Erfindung ist jede raumfeste Anordnung der Mehrzahl von LEDs zu verstehen. Die Modulfläche ist dabei als eine sämtliche LEDs verbindende Fläche zu verstehen. Die Modulfläche kann im Sinne der Erfindung auch eine Wölbung aufweisen, zum Beispiel eine tonnenartige Wölbung in der Querrichtung. Bevorzugt ist die Modulfläche aber eben.

Das Modul ist allgemein vorteilhaft, aber nicht notwendig als integriertes Chip-On-Board-Modul (COB) ausgebildet, bei dem die LEDs und gegebenenfalls weitere Elektronikbauteile auf einem flächigen Träger angeordnet sind.

Ganz allgemein kann die erfindungsgemäße Leuchte insbesondere in der Längsrichtung beliebig erstreckt sein. Eine Erstreckung in der Querrichtung hängt vorrangig von den Anforderungen an Anzahl, Leistung und Intensität der Linien auf der Zielfläche ab. Bezüglich der Erstreckung in der Längsrichtung können je nach geforderter Länge mehrere Module unmittelbar hintereinander angeordnet werden, was analog auch für gegebenenfalls verwendete Optiken gilt.

Bei einer allgemein vorteilhaften Weiterbildung der Erfindung umfasst die Optik zumindest eine zweite, in der Längsrichtung erstreckte Zylinderlinse, wobei das Licht zumindest einiger der LEDs einer zweiten der Reihen mittels der zweiten Zylinderlinse in eine Linie auf einer Zielfläche gebündelt werden. Auf diese Weise können mehrere Reihen von LEDs des Moduls in Linien gebündelt werden, wobei jeweils ein großer Öffnungswinkel des Lichts auch in der Querrichtung erfasst und transportiert werden kann.

In bevorzugter, aber nicht notwendiger Detailgestaltung bündeln dabei die erste Zylinderlinse und die zweite Zylinderlinse das Licht in dieselbe Linie auf der Zielfläche. Dies sorgt für eine besonders große Helligkeit in der Zielfläche. Die Homogenität der Lichtintensität entlang der Linie kann dabei auf einfache Weise weiter verbessert werden, etwa indem die LEDs der beiden Reihen in der Längsrichtung versetzt zueinander angeordnet sind. Alternativ oder ergänzend dazu kann eine weitere Optimierung der Homogenität auch durch Maßnahmen seitens der bündelnden Optik erfolgen.

Bei einem bevorzugten Ausführungsbeispiel der Erfindung umfasst die Optik eine Primäroptik zur Bündelung des abgestrahlten Lichts, wobei die Primäroptik eine Mehrzahl von unmittelbar auf den LEDs angeordneten Linsen umfasst. Durch eine solche Primäroptik lässt sich ein besonders großer Raumwinkel des von den LEDs meist großwinkelig abgestrahlten Lichtes transportieren. Zum Beispiel kann es sich dabei um mehrere, jeweils über einer LED angeordnete Sammellinsen handeln. Grundsätzlich kann auch die Zylinderlinse Bestandteil der Primäroptik sein und unmittelbar über einer Mehrzahl der LEDs angeordnet sein.

Alternativ oder ergänzend zu einer Sammellinse oder Zylinderlinse kann die Primäroptik auch Reflektoren umfassen, die unmittelbar seitlich der LEDs angeordnet sind und einen nutzbaren Raumwinkelbereich des transportierten Lichts weiter verbessern. Es kann sich zum Beispiel um rotationssymmetrische, jeweils einzelnen LEDs zugeordnete Reflektoren.

Bei einer bevorzugten Weiterbildung ist die Primäroptik als auf die Module aufgebrachte, transparente Polymerschicht ausgebildet ist, die zumindest mehrere LEDs einstückig übergreift. Eine solche Polymerschicht kann zum Beispiel nach Art der in WO 2012/031703 A1 beschriebenen Optiken ausgebildet sein. Dabei wird ein LED-Modul mittels einer offenen Gießform mit einem UV-beständigen Silikon überzogen.

Bei einer bevorzugten Weiterbildung einer Primäroptik sind die über den LEDs angeordneten Linsen mit einem seitlichen Versatz in der Querrichtung gegenüber einem Zentrum der LEDs positioniert . Dies ermöglicht eine gute Bündelung eines großen Öffnungswinkels in der Querrichtung, wenn die Linie der Zielfläche sich nicht in der geometrischen Abstrahlrichtung der LEDs der Reihe befindet. So kann in bevorzugter Weiterbildung zum Beispiel der Versatz umso größer sein, je weiter die LED-Reihe in der Querrichtung von der Linie entfernt ist. Insbesondere kann eine zentrale LED-Reihe vorliegen, deren geometrische Abstrahlrichtung die Linie schneidet, wobei die Linse oder Linsen dieser Reihe keinen Versatz aufweisen.

Erfindungsgemäß liegen wenigstens 50% des von den LEDs emittierten Lichtes in einem Wellenlängenbereich von weniger als 470nm vor. Dies ermöglicht eine zumindest überwiegende Auslegung der Leuchte als UV-Strahler. Durch die weitere Kombination der erfindungsgemäßen Merkmale kann der UV-Strahler flexibel in einer technischen Vorrichtung, zum Beispiel einer Druckmaschine, eingebaut werden.

Offenbart wird ferner eine Leuchte, für die wenigstens 50% des von den LEDs emittierten Lichtes in einem Wellenlängenbereich von mehr als 780nm vorliegen. Dies ermöglicht eine zumindest überwiegende Auslegung der Leuchte als IR-Strahler. Durch die weitere Kombination der erfindungsgemäßen Merkmale kann der IR-Strahler flexibel in einer technischen Vorrichtung, zum Beispiel einer Druckmaschine, eingebaut werden.

Bei einer besonders bevorzugten Ausführungsform der Erfindung umfasst die Optik eine Sekundäroptik, die räumlich getrennt von dem Modul in einem Strahlengang des Lichts angeordnet ist. In Abgrenzung zum Begriff einer Primäroptik wird unter einer Sekundäroptik vorliegend allgemein eine Optik verstanden, die nicht unmittelbar auf den LEDs aufsitzt. Es sind daher Ausführungsformen möglich, die eine Sekundäroptik, aber keine Primäroptik umfassen, sowie umgekehrt. Bei einer besonders bevorzugten Ausführungsform sind sowohl eine Primäroptik als auch eine Sekundäroptik in dem Strahlengang der Leuchte angeordnet, wodurch eine besonders kleine Bauform bei hoher und homogener Beleuchtungsstärke resultiert.

In bevorzugter Detailgestaltung ist die Sekundäroptik als transparente Polymerschicht auf einem transparenten Substrat ausgebildet. Die Sekundäroptik kann dabei nach Art der in WO 2012/031703 A1 beschriebenen Optiken hergestellt sein, wobei an Stelle eines LED-Moduls ein transparentes Substrat, zum Beispiel Glass, mittels einer offenen Gießform mit einem UV-beständigen Silikon überzogen wird.

In besonders bevorzugter Detailgestaltung ist die Zylinderlinse an der Sekundäroptik ausgebildet, wodurch eine homogene Bündelung des von den LEDs abgestrahlten Lichts in die Linie besonders effektiv erfolgt. Besonders bevorzugt kann dabei die Sekundäroptik mehrere in einer Ebene nebeneinander angeordnete Zylinderlinsen umfassen. Somit kann eine Zylinderlinse jeweils das Licht einer der Reihen der LEDs oder auch mehrerer nebeneinander liegender Reihen bündeln, so dass insgesamt eine große Anzahl von LED-Reihen zur der Gesamtintensität der Leuchte beitragen können. Insbesondere können die verschiedenen Zylinderlinsen das Licht der LEDs jeweils in dieselbe Linie bündeln.

Bei einer möglichen Ausführungsform der Erfindung ist die Ebene der Zylinderlinsen relativ zu der Modulfläche und/oder zu der Zielfläche geneigt. Hierdurch lässt sich auf einfache Weise ein Versatz zwischen der Linie und einer Position des Moduls in der Querrichtung kompensieren. So können zum Beispiel in der Querrichtung auf jeder Seite der Linie Module vorgesehen sein, die in jeweils entgegen gesetzter Kipprichtung gegenüber einer Sekundäroptik angestellt sind und somit eine besonders effektive Bündelung in die Linie erlauben. Auch eine geneigte Anordnung der Sekundäroptik oder auch des Moduls und der Sekundäroptik gegenüber der Zielfläche sind möglich.

Bei einer weiteren Ausführungsform der Erfindung ist es vorgesehen, dass eine Mittelebene der Reihe von LEDs und eine hierzu parallele optische Zentralebene einer das Licht der Reihe bündelnden Zylinderlinse einen Versatz in der Querrichtung zueinander aufweisen. Auch hierdurch ist eine einfache und effektive Bündelung eines großen Öffnungswinkels in die Linie erzielbar, insbesondere wenn die Linie in Querrichtung versetzt gegenüber der Mittelebene der LEDs angeordnet ist. In weiterer Optimierung kann ein solcher Versatz zu einer zugeordneten Zylinderlinse für verschiedene Reihen der LEDs verschieden groß sein, je nachdem, welchen Abstand die Linie von der LED-Reihe in der Querrichtung hat.

Allgemein vorteilhaft ist es vorgesehen, dass eine Packungsdichte der LEDs in der Längsrichtung größer ist als in der Querrichtung. Die geringere Packungsdichte in der Querrichtung kann durch eine optimierte, erfindungsgemäße Transportoptik ausgeglichen werden, so dass insgesamt mit weniger LEDs dieselbe Intensität auf der Zielfläche erreicht werden kann. Zum Beispiel kann das Modul ein COB-Modul sein, bei dem die Packungsdichte in der Längsrichtung maximal ist. Dies wird regelmäßig durch die technischen Bestückungsmöglichkeiten solcher Module limitiert. Eine in Längsrichtung maximale Packungsdichte ist zugleich optimal für die Homogenität der Intensitätsverteilung auf der Linie. Die Packungsdichte in der Querrichtung kann zum Beispiel nur 80%, bevorzugt nicht mehr als 60% einer Packungsdichte in der Längsrichtung aufweisen.

Die Aufgabe der Erfindung wird zudem durch eine Vorrichtung zum Trocknen einer Beschichtung gelöst, umfassend eine erfindungsgemäße Leuchte. Die erfindungsgemäße Leuchte ist hierzu besonders gut geeignet, da sie hohe Bestrahlungsstärken mit flexibler und insbesondere kompakter Bauform kombiniert. Gemäß der Vorrichtung sind ein flächiges Substrat mit der zu trocknenden Beschichtung und die Leuchte in einer Förderrichtung zueinander bewegbar, wobei sich die Leuchte in einer Querrichtung zumindest teilweise über eine Breite des Substrats erstreckt und in definiertem Abstand über dem Substrat angeordnet ist. Hierunter ist auch ein rasterndes Abfahren der Substratfläche in mehreren Bahnen zu verstehen. Ferner ist das Substrat ein Druckerzeugnis, das in einer Druckmaschine mit aufgedrucktem Lack beschichtet wird. Demnach ist die erfindungsgemäße Vorrichtung eine Druckmaschine und die zu trocknende Beschichtung ist ein aufgedruckter Lack.

Die Aufgabe der Erfindung wird zudem durch die Verwendung einer erfindungsgemäßen Leuchte zum Trocknen einer Beschichtung gelöst, bevorzugt in einem Druckverfahren, wobei das Trocknen der Beschichtung ein UV-Trocknen eines Lacks oder einer Farbe in einer Druckmaschine ist.

Weitere Vorteile und Merkmale der Erfindung ergeben sich aus dem nachfolgend beschriebenen Ausführungsbeispiel sowie aus den abhängigen Ansprüchen.

Nachfolgend werden mehrere bevorzugte Ausführungsbeispiele der Erfindung beschrieben und anhand der anliegenden Zeichnungen näher erläutert.
- Fig. 1: zeigt eine schematische Darstellung eines ersten Ausführungsbeispiels einer erfindungsgemäßen Leuchte.
- Fig. 2: zeigt eine schematische Anordnung von LEDs aus einem LED-Modul der Leuchte gemäß Fig. 1.
- Fig. 3: zeigt eine Schnittansicht der Leuchte aus Fig. 1 in einer Längsrichtung.
- Fig. 4: zeigt eine Abwandlung der Leuchte aus Fig. 1.
- Fig. 5: zeigt eine Darstellung eines zweiten Ausführungsbeispiels der Erfindung.
- Fig. 6: zeigt eine Darstellung eines dritten Ausführungsbeispiels der Erfindung.
- Fig. 7: zeigt eine Darstellung eines vierten Ausführungsbeispiels der Erfindung.

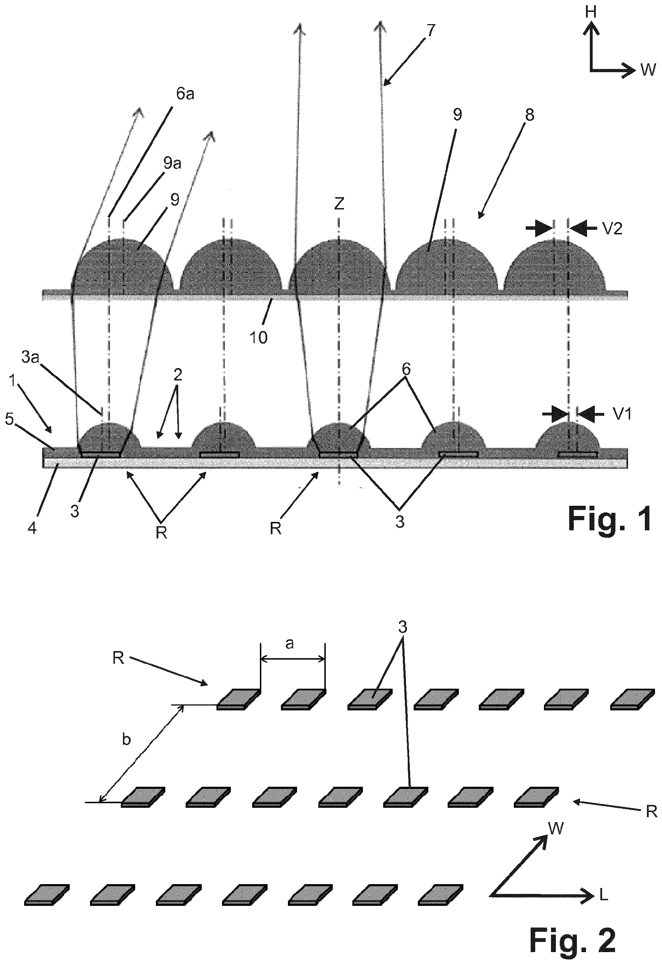

Eine erfindungsgemäße Leuchte gemäß Fig. 1 umfasst ein LED-Modul 1 mit jeweils mehrere LEDs 3, die in einem Raster über eine senkrecht zur Zeichnungsebene verlaufende Modulfläche 2 verteilt sind. Die LEDs 3 sind zusammen mit weiteren elektronischen Komponenten (nicht dargestellt) auf einem ebenen Träger 4 aufgebracht, wodurch insgesamt ein Chip-On-Board-Modul (COB) ausgebildet ist. Das Modul 1 erstreckt sich in einer in Fig. 1 senkrecht zur Zeichnungsebene verlaufenden Längsrichtung L und in einer Querrichtung W, die in der Zeichnung Fig. 1 von links nach rechts verläuft. Eine geometrische Hauptabstrahlrichtung H der LEDs 3 verläuft senkrecht zu der Längsrichtung L und der Querrichtung W.

Die im Raster angeordneten LEDs 3 verlaufen in Reihen R in der Längsrichtung, in denen sie einen ersten Wiederholabstand a haben. In der Querrichtung sind die Reihen R parallel zueinander und haben einen Wiederholabstand b. Vorliegend sind etwa zehn Reihen R von LEDs nebeneinander angeordnet, die in den Zeichnungen nicht sämtlich dargestellt sind.

Durch die Kehrwerte der Wiederholabstände a, b sind Packungsdichten der LEDs in den jeweiligen Richtungen definiert. Vorliegend beträgt der Abstand a je nach Detailgestaltung 2 mm bis 5 mm, wobei die LEDs eine abstrahlende Fläche in der Größenordnung von etwa 1 mm² haben. Der Abstand b beträgt typisch zwischen 5 mm und 10 mm und ist rund doppelt so groß wie der Abstand a. Demnach ist die Packungsdichte in der Querrichtung W nur etwa halb so groß wie in der Längsrichtung L.

Insbesondere in der Längsrichtung, bei Bedarf aber auch in der Querrichtung, können jeweils mehrere Module 1 hintereinander angeordnet sein, je nach Anforderungen der Baugröße der Leuchte. Zweckmäßig sind die aufeinanderfolgenden Module dabei so mit LEDs 3 bestückt bzw. hintereinander angeordnet, dass die Abstände der LEDs gleich sind bzw. möglichst keine Veränderung in der Verteilung des abgestrahlten Lichts im Bereich der Modulgrenzen besteht.

Auf den Modulen 1 ist eine Primäroptik 5 angeordnet, die vorliegend als vollflächige Beschichtung der Module 1 ausgebildet ist. Die Primäroptik 5 weist unmittelbar auf den einzelnen LEDs 3 jeweils Linsen 6, vorliegend plankonvexe Sammellinsen, auf, mittels derer ein großer Öffnungswinkel des abgestrahlten Lichts gebündelt wird. Dabei erfolgt eine überwiegende Bündelung der Strahlen in eine Struktur in Form einer geraden, in der Längsrichtung verlaufenden Linie in einer Zielfläche (nicht dargestellt). Auf dieser Linie beträgt die Bestrahlungsstärke durch die Leuchte vorliegend deutlich mehr als 2 W/cm².

Zur Veranschaulichung sind in Fig. 1 zwei randseitig extremale Strahlengänge 7 eingezeichnet, die konvergieren und sich weiter oberhalb auf der nicht dargestellten Linie bzw. Zielfläche treffen.

Die Module 1 können auf Kühlkörpern (nicht dargestellt) angeordnet sein. Die Kühlkörper haben bevorzugt Anschlüsse für Eintritt und Austritt eines flüssigen Kühlmittels, das die Kühlkörper zum Abtransport der Wärme durchströmt. Das Kühlmittel kann in einem geschlossenen Kreislauf vorliegen und die Wärme an anderer Stelle über einen Wärmetauscher wieder abgeben. Bei der vorliegenden Leuchte treten abzuführende Wärmeleistungen im Bereich von wesentlich mehr als 1 kW auf.

Zusätzlich zu der Primäroptik 1 ist eine Sekundäroptik 8 vor den Modulen 1 vorgesehen, wodurch die Bündelung eines möglichst großen Austrittswinkels aus den LEDs in die Struktur auf der Zielfläche weiter verbessert wird. Die Sekundäroptik 8 ist beabstandet vor dem Modul 1, aber zwischen dem Modul 1 und der Zielfläche angeordnet. Der Abstand zwischen Sekundäroptik 8 und der Modulfläche 2 ist wesentlich kleiner als der Abstand der Sekundäroptik 8 von der Zielfläche, um möglichst früh bündelnd auf den Strahlengang einzuwirken.

Die Sekundäroptik 8 umfasst jeweils mehrere parallele Zylinderlinsen 9, die in der Längsrichtung L erstreckt und in der Querrichtung W parallel zueinander und in einer Ebene angeordnet sind. Somit wird das Licht zumindest jeweils einer Reihe von LEDs 3 von einer der Zylinderlinsen 12 erfasst und in die Linie bzw. Struktur der Zielfläche 10 (Druckerzeugnis) gebündelt. Exemplarisch sind in Fig. 1 verschiedene Lichtstrahlen von zwei LEDs unter jeweils unterschiedlichem Abstrahlwinkel eingezeichnet, die sämtlich in dieselbe linienförmige Struktur in der Zielfläche gebündelt werden. Die Linie hat dabei eine Breite in der Querrichtung Q, die erheblich kleiner ist als der Abstand der äußeren Reihen R von LEDs 3 in der Querrichtung.

Bei einer vereinfachten, nicht dargestellten Ausführungsform der Erfindung kann auf die Sekundäroptik verzichtet werden, wobei die Zylinderlinsen unmittelbar in der Primäroptik ausgebildet sind und sich über die einzelnen Reihen R der LEDs 3 erstrecken.

Wie in Fig. 1 durch eingezeichnete Symmetrielinien erkennbar ist, besteht vorliegend in der Querrichtung ein seitlicher Versatz V1 einer Mitte 3a der LEDs 3 zu einer Mitte 6a ihrer Linsen 6 der Primäroptik 5.

Zudem haben die Mitten 6a der Linsen 6 als auch eine Mittelebene bzw. Mitte 3a der Reihe von LEDs 3 einen seitlichen Abstand bzw. Versatz V1+V2 in der Querrichtung zu einer optischen Zentralebene 9a einer das Licht dieser Reihe R bündelnden Zylinderlinse 9. V2 ist dabei der Versatz der Mitte 6a der Linsen 6 der Primäroptik zu der optischen Zentralebene 9a der Zylinderlinse. Dieser Versatz V1+V2 ist umso größer, je weiter die jeweilige Reihe R zu einer zentralen, mit der Linie der Zielfläche zusammenfallenden Mittelebene Z in der Querrichtung versetzt ist. Für eine Reihe R, die symmetrisch auf der Mittelebene Z angeordnet ist (siehe mittlere Reihe R in Fig. 1) liegt entsprechend kein Versatz vor.

Ein Vergleich der in Fig. 1 eingezeichneten Strahlengänge der linken, äußeren Reihe R und der mittleren, auf der Zentralebene Z angeordneten Reihe R von LEDs 3 verdeutlicht dies. Die Lichtstrahlen der randseitigen LEDs müssen in einem Winkel zu der Hauptabstrahlrichtung (Senkrechte auf die Modulfläche) gebündelt werden, um die Linie in der Zielfläche zu treffen. Durch den jeweiligen seitlichen Versatz V1, V2 wird die Bündelung eines möglichst großen Öffnungswinkels der äußeren LEDs 3 in diesen Strahlengang optimiert.

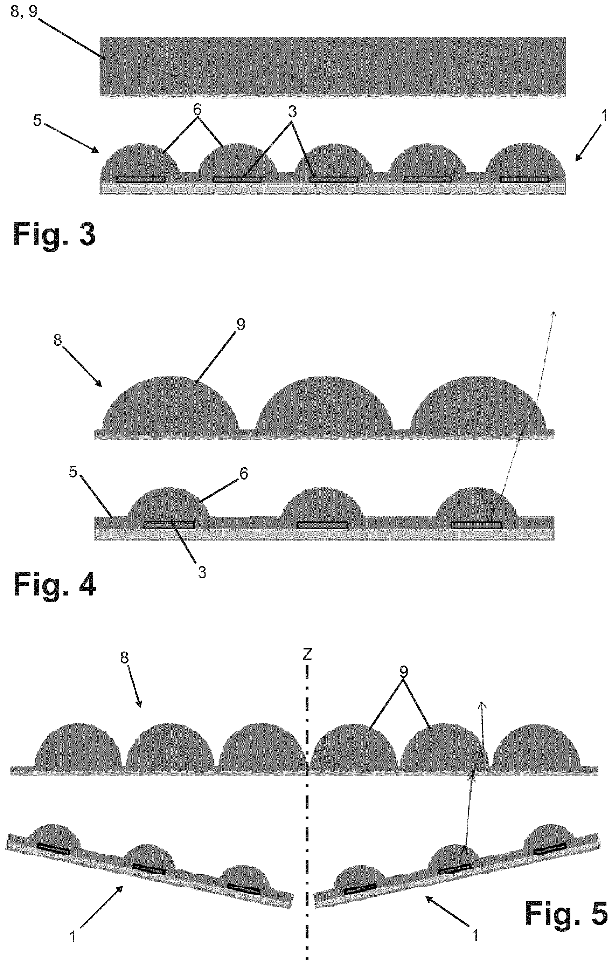

Bei der in Fig. 4 gezeigten Abwandlung liegt kein Versatz der LEDs 3 bzw. Linsen 6, 9 vor, so dass eine Bündelung der Reihen R jeweils in nebeneinander liegende Linien auf der Zielfläche erfolgt. Je nach Schärfe der Bündelung können diese Linien aber auch so stark überlappen, dass insgesamt eine relativ breite Linie entsteht, die auch eine gute Homogenität in der Querrichtung aufweisen kann.

Im Fall des in Fig. 5 dargestellten Ausführungsbeispiels der Erfindung ist die Sekundäroptik 8 wie im ersten Ausführungsbeispiel ausgebildet, wobei sämtliche Zylinderlinsen 9 in einer zu der Zielfläche parallelen Ebene liegen. Vor der Sekundäroptik sind in der Querrichtung zwei Module 1 mit Primäroptiken 5 nebeneinander angeordnet, die jeweils in entgegengesetzter Richtung um denselben Winkelbetrag gegenüber der Sekundäroptik geneigt sind. Eine Zentralebene Z verläuft hier symmetrisch zwischen zwei Zylinderlinsen 9 bzw. zwischen jeweils einer linken, inneren LED 3 des linken Moduls und einer rechten, inneren LED 3 des rechten Moduls. Die Verkippung der Module 1 wie im ersten Beispiel eine Bündelung sämtlicher Reihen von LEDs R auf dieselbe Linie in der Zielfläche.

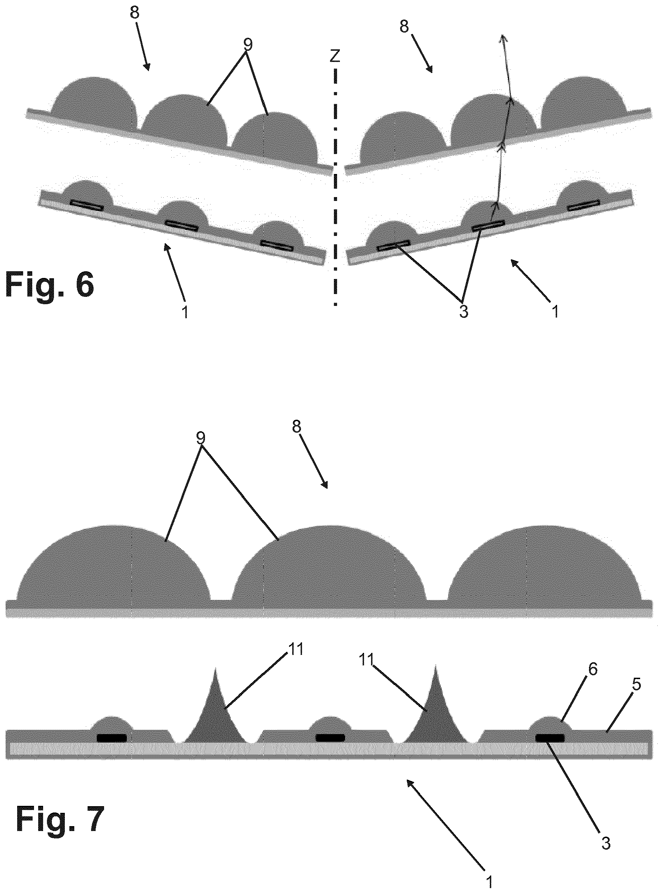

Bei dem Beispiel nach Fig. 6 ist im Unterschied zum Beispiel nach Fig. 5 vorgesehen, dass eine erste Sekundäroptik 8 links von der Zentralebene Z und eine zweite Sekundäroptik 8 rechts von der Zentralebene Z vorgesehen ist. Die Sekundäroptiken 8 sind hierbei ebenso wie die Primäroptiken 5 entgegen gesetzt geneigt angeordnet, um die Bündelung des Lichts der LED-Reihen R in dieselbe Linie bei zugleich möglichst großem Öffnungswinkel zu begünstigen. Vorliegend verlaufen die einander zugeordneten Primäroptiken 5 und Sekundäroptiken jeweils wieder parallel zueinander, wobei je nach Optimierung und Anforderungen auch hier eine geneigte Anordnung vorgesehen sein kann.

Bei dem Ausführungsbeispiel nach Fig. 7 sind im Unterschied zum ersten Ausführungsbeispiel zusätzliche Reflektoren 11 unmittelbar seitlich der LEDs 3 angeordnet. Hierdurch wird auch unter sehr großen Winkeln abgestrahltes Licht in den nutzbaren Strahlengang eingelenkt. Vorliegend erstrecken sich die Reflektoren 11 als prismatische Körper über die Längsrichtung des Moduls 1, wobei die reflektierenden Seitenwände konkav gebogen geformt sind.

Vorliegend werden die Primäroptiken nach einem in der WO 2012/031703 A1 im Prinzip beschriebenen Verfahren hergestellt, indem die COB-Module durch Silikon in einer offenen Gießform beschichtet werden. Die vorliegenden Sekundäroptiken werden nach einem analogen Verfahren hergestellt, bei dem an Stelle der COB-Module ein transparentes, flaches Substrat 10 mit UV-beständigem Silikon beschichtet wird, um die optisch wirksamen Strukturen 9 (Zylinderlinsen) zu erzeugen.

Eine Leuchte gemäß der vorstehend beschriebenen Ausführungsbeispiele wird zu Zwecken der UV-Trocknung von Lack bzw. Farbe in einer Druckmaschine, vorliegend Offset-Bodendruckmaschine, eingesetzt. Eine Erstreckung der Leuchte in der Längsrichtung beträgt typisch mehr als 1 Meter, im vorliegenden Beispiel 1,6 Meter, was der Bogenbreite des Druckerzeugnisses entspricht. Zur Realisierung solcher Längen werden typisch jeweils mehrere Module 1 und Sekundäroptiken 8 in der Längsrichtung hintereinander angeordnet.

Die vorstehend beschriebenen Komponenten der Leuchte sind in einem bezüglich des Bauraums optimierten Gehäuse (nicht dargestellt) aufgenommen.

Eine Bestrahlungsstärke auf der Zielfläche bezogen auf die Längsrichtung beträgt vorliegend rund 10 Watt pro cm. Dabei liegt der überwiegende Teil des Lichtes im Bereich einer Wellenlänge von weniger als 470 nm.

Um LED-Leuchten mit sehr hohen optischen Ausgangsleistungen herzustellen, werden 0,1-200 mm², typisch 1-2 mm² große LEDs im Chip-on-Board-Verfahren (COB) aufgebaut. Dabei werden mehrere LEDs, typisch 4-200 Chips, auf einem gemeinsamen Substrat mit einer Fläche in der Größenordnung von 5 bis 50 cm² zu einem Modul assembliert. Durch Aneinanderreihung von mit LEDs bestückten Modulen wird die gewünschte Lampengröße generiert.

## Patentansprüche

1. Leuchte, umfassend
zumindest ein Modul (1) mit einer Mehrzahl von über eine Modulfläche (2) verteilten LEDs (3),
wobei in einer Längsrichtung (L) des Moduls (1) mehrere LEDs in einer Reihe (R) angeordnet sind, und wobei in einer zu der Längsrichtung (L) senkrechten Querrichtung (W) des Moduls (1) mehrere der Reihen (R) nebeneinander angeordnet sind,
und wobei die LED-Leuchte eine Optik (5, 8) zur Bündelung des von den LEDs emittierten Lichts umfasst,
wobei die Optik (5, 8) zumindest eine erste, in der Längsrichtung erstreckte Zylinderlinse (9) umfasst,
wobei das Licht zumindest einiger der LEDs (3) einer ersten der Reihen (3) mittels der ersten Zylinderlinse (9) in eine Linie auf einer Zielfläche gebündelt wird,
**dadurch gekennzeichnet, dass** wenigstens 50% des von den LEDs emittierten Lichtes in einem Wellenlängenbereich von weniger als 470nm liegen.

2. Leuchte nach Anspruch 1, **dadurch gekennzeichnet, dass** die Optik (5, 8) zumindest eine zweite, in der Längsrichtung erstreckte Zylinderlinse (9) umfasst, wobei das Licht zumindest einiger der LEDs (3) einer zweiten der Reihen (3) mittels der zweiten Zylinderlinse (9) in eine Linie auf einer Zielfläche gebündelt wird.

3. Leuchte nach Anspruch 2, **dadurch gekennzeichnet, dass** die erste Zylinderlinse (9) und die zweite Zylinderlinse (9) das Licht in dieselbe Linie auf der Zielfläche bündeln.

4. Leuchte nach einem der vorhergehenden Ansprüche, **dadurch gekennzeichnet, dass** die Optik eine Sekundäroptik (8) umfasst, die räumlich getrennt von dem Modul (1) in einem Strahlengang des Lichts angeordnet ist.

5. Leuchte nach Anspruch 4, **dadurch gekennzeichnet, dass** die Leuchte keine Primäroptik umfasst.

6. Leuchte nach Anspruch 4 oder 5, **dadurch gekennzeichnet, dass** die Sekundäroptik (8) nicht unmittelbar auf den LEDs aufsitzt.

7. Leuchte nach einem der Ansprüche 4 bis 6, **dadurch gekennzeichnet, dass** die Sekundäroptik (8) als transparente Polymerschicht auf einem transparenten Substrat (10) ausgebildet ist.

8. Leuchte nach einem der Ansprüche 4 bis 7, **dadurch gekennzeichnet, dass** die Zylinderlinse (9) an der Sekundäroptik (8) ausgebildet ist.

9. Leuchte nach Anspruch 8, **dadurch gekennzeichnet, dass** die Sekundäroptik (8) mehrere in einer Ebene nebeneinander angeordnete Zylinderlinsen (9) umfasst.

10. Leuchte nach einem der vorhergehenden Ansprüche, **dadurch gekennzeichnet, dass** eine Mittelebene (3a) der Reihe von LEDs (R) und eine hierzu parallele optische Zentralebene (9a) einer das Licht der Reihe bündelnden Zylinderlinse (9) einen Versatz (V2+V1) in der Querrichtung (W) zueinander aufweisen.

11. Leuchte nach Anspruch 10, **dadurch gekennzeichnet, dass** der Versatz (V2+V1) zu einer zugeordneten Zylinderlinse für verschiedene Reihen der LEDS (R) verschieden groß ist, insbesondere je nachdem, welchen Abstand die Linie von der mittleren LED-Reihe in der Querrichtung hat.

12. Leuchte nach einem der vorhergehenden Ansprüche, **dadurch gekennzeichnet, dass** eine Packungsdichte der LEDs in der Längsrichtung (L) größer ist als in der Querrichtung (W).

13. Leuchte nach Anspruch 12, **dadurch gekennzeichnet, dass** die Packungsdichte der LEDs in der Querrichtung (W) nicht mehr als 60% der Packungsdichte der LEDs in der Längsrichtung (L) beträgt.

14. Leuchte nach einem der Ansprüche 1 bis 12, **dadurch gekennzeichnet, dass** die LEDs in einem Raster angeordnet sind,
wobei in dem Raster die Reihen (R) in der Längsrichtung (L) verlaufen und die Reihen (R) in der Querrichtung (W) parallel zueinander sind,
wobei die LEDs in der Längsrichtung (L) einen ersten Wiederholabstand a haben,
wobei die LEDs in der Querrichtung (W) einen Wiederholabstand b haben.

15. Leuchte nach Anspruch 14, **dadurch gekennzeichnet, dass** der Wiederholabstand a 2 mm bis 5 mm beträgt,
wobei die LEDs eine abstrahlende Fläche in der Größenordnung von etwa 1 mm² haben.

16. Leuchte nach Anspruch 14 oder 15, **dadurch gekennzeichnet, dass** der Wiederholabstand b zwischen 5 mm und 10 mm beträgt und doppelt so groß ist wie der Wiederholabstand a.

17. Leuchte nach einem der vorhergehenden Ansprüche, **dadurch gekennzeichnet, dass** das Modul (1) als integriertes Chip-on-Board-Modul ausgebildet ist, bei dem die LEDs (3) auf einem flächigen Träger angeordnet sind.

18. Leuchte nach Anspruch 17, **dadurch gekennzeichnet, dass** zusätzlich weitere Elektronikbauteile auf dem flächigen Träger angeordnet sind.

19. Leuchte nach einem der vorhergehenden Ansprüche, **dadurch gekennzeichnet, dass** in der Längsrichtung (L) mehrere Module (1) und gegebenenfalls Sekundäroptiken (8) hintereinander angeordnet sind.

20. Leuchte nach einem der vorhergehenden Ansprüche, **dadurch gekennzeichnet, dass** das Modul (1) auf einem Kühlkörper angeordnet ist.

21. Vorrichtung zum Trocknen einer Beschichtung, umfassend eine Leuchte nach einem der vorhergehenden Ansprüche, wobei ein flächiges Substrat mit der zu trocknenden Beschichtung und die Leuchte in einer Förderrichtung zueinander bewegbar sind, wobei sich die Leuchte in einer Querrichtung zumindest teilweise über eine Breite des Substrats erstreckt und in definiertem Abstand über dem Substrat angeordnet ist,
wobei die Vorrichtung eine Druckmaschine ist,
wobei das flächige Substrat ein Druckerzeugnis ist,
wobei die zu trocknende Beschichtung ein aufgedruckter Lack ist.

22. Verwendung einer Leuchte nach einem der Ansprüche 1 bis 20 zum Trocknen einer Beschichtung, insbesondere in einem Druckverfahren, wobei das Trocknen der Beschichtung ein UV-Trocknen eines Lacks oder einer Farbe in einer Druckmaschine ist.

23. Verwendung nach Anspruch 22, **dadurch gekennzeichnet, dass** die Druckmaschine eine Offset-Bodendruckmaschine ist.

## Claims

1. Luminaire comprising
at least one module (1) with a plurality of LEDs (3) distributed over a module surface (2),
a plurality of LEDs being arranged in a row (R) in a longitudinal direction (L) of the module (1), and a plurality of the rows (R) being arranged next to one another in a transverse direction (W) of the module (1) which is perpendicular to the longitudinal direction (L),
and wherein the LED light comprises optics (5, 8) for focusing the light emitted by the LEDs, the optics (5, 8) comprising at least a first cylindrical lens (9) extending in the longitudinal direction,
wherein the light of at least some of the LEDs (3) of a first one of the rows (3) is focused into a line on a target surface by means of the first cylindrical lens (9),
**characterized in that** at least 50% of the light emitted by the LEDs is in a wavelength range of less than 470nm.

2. Luminaire according to claim 1, **characterized in that** the optic (5, 8) comprises at least one second cylindrical lens (9) extending in the longitudinal direction, the light of at least some of the LEDs (3) of a second of the rows (3) being bundled by means of the second cylindrical lens (9) into a line on a target surface.

3. Luminaire according to claim 2, **characterized in that** the first cylindrical lens (9) and the second cylindrical lens (9) concentrate the light in the same line on the target surface.

4. Luminaire according to one of the preceding claims, **characterized in that** the optics comprises a secondary optical system (8) which is spatially separated from the module (1) and arranged in a beam path of the light.

5. Luminaire according to claim 4, **characterised in that** the luminaire does not comprise any primary optics.

6. Luminaire according to claim 4 or 5, **characterised in that** the secondary optics (8) do not sit directly on the LEDs.

7. Luminaire according to one of claims 4 to 6, **characterized in that** the secondary optics (8) is formed as a transparent polymer layer on a transparent substrate (10).

8. Luminaire according to one of claims 4 to 7, **characterized in that** the cylindrical lens (9) is formed on the secondary optics (8).

9. Luminaire according to claim 8, **characterized in that** the secondary optics (8) comprise a plurality of cylindrical lenses (9) arranged side by side in a plane.

10. Luminaire according to one of the preceding claims, **characterized in that** a central plane (3a) of the row of LEDs (R) and an optical central plane (9a) parallel thereto of a cylindrical lens (9) bundling the light of the row have an offset (V2+V1) in the transverse direction (W) with respect to one another.

11. A luminaire according to claim 10, **characterized in that** the offset (V2+V1) to an associated cylindrical lens for different rows of LEDS (R) is different, in particular depending on the distance of the line from the middle row of LEDS in the transverse direction.

12. Luminaire according to one of the preceding claims, **characterized in that** a packing density of the LEDs is greater in the longitudinal direction (L) than in the transverse direction (W).

13. Luminaire according to claim 12, **characterized in that** the packing density of the LEDs in the transverse direction (W) is not more than 60% of the packing density of the LEDs in the longitudinal direction (L).

14. Luminaire according to one of claims 1 to 12, **characterized in that** the LEDs are arranged in a grid,
in which grid the rows (R) extend in the longitudinal direction (L) and the rows (R) are parallel to each other in the transverse direction (W),
wherein the LEDs have a first repetition distance a in the longitudinal direction (L),
the LEDs having a repetition distance b in the transverse direction (W).

15. Lamp according to claim 14, **characterised in that** the repetition distance a is 2 mm to 5 mm,
wherein the LEDs have a radiating area of the order of about 1 mm2.

16. Lamp as claimed in claim 14 or 15, **characterised in that** the repeat distance b is between 5 mm and 10 mm and is twice the repeat distance a.

17. Luminaire according to one of the preceding claims, **characterized in that** the module (1) is designed as an integrated chip-on-board module, in which the LEDs (3) are arranged on a flat carrier.

18. Luminaire according to claim 17, **characterised in that** further electronic components are additionally arranged on the flat support.

19. Luminaire according to one of the preceding claims, **characterized in that** a plurality of modules (1) and optionally secondary optics (8) are arranged one behind the other in the longitudinal direction (L).

20. Luminaire according to one of the preceding claims, **characterized in that** the module (1) is arranged on a heat sink.

21. Device for drying a coating, comprising a light according to one of the preceding claims, wherein a flat substrate with the coating to be dried and the light are movable relative to one another in a conveying direction, wherein the light extends in a transverse direction at least partially over a width of the substrate and is arranged at a defined distance above the substrate,
wherein the device is a printing machine,
wherein the planar substrate is a printed product,
wherein the coating to be dried is a printed lacquer.

22. Use of a lamp according to any one of claims 1 to 20 for drying a coating, in particular in a printing process, wherein drying the coating is UV drying of a varnish or ink in a printing machine.

23. Use according to claim 22, **characterized in that** the printing machine is an offset floor printing machine.

## Revendications

1. Luminaire comprenant
au moins un module (1) avec une pluralité de LED (3) réparties sur une surface de module (2), une pluralité de LED étant disposées dans une rangée (R) dans une direction longitudinale (L) du module (1), et une pluralité des rangées (R) étant disposées les unes à côté des autres dans une direction transversale (W) du module (1) qui est perpendiculaire à la direction longitudinale (L),
et dans laquelle la lumière LED comprend des optiques (5, 8) pour focaliser la lumière émise par les LED,
l'optique (5, 8) comprenant au moins une première lentille cylindrique (9) s'étendant dans la direction longitudinale,
dans laquelle la lumière d'au moins certaines des LED (3) d'une première rangée (3) est focalisée en une ligne sur une surface cible au moyen de la première lentille cylindrique (9),
**caractérisé en ce qu'**au moins 50 % de la lumière émise par les LED se situe dans une plage de longueurs d'onde inférieure à 470 nm.

2. Luminaire selon la revendication 1, **caractérisé en ce que** l'optique (5, 8) comprend au moins une deuxième lentille cylindrique (9) s'étendant dans la direction longitudinale, la lumière d'au moins une partie des LED (3) d'une deuxième rangée des rangées (3) étant focalisée au moyen de la deuxième lentille cylindrique (9) sur une surface cible.

3. Luminaire selon la revendication 2, **caractérisé en ce que** la première lentille cylindrique (9) et la seconde lentille cylindrique (9) concentrent la lumière dans la même ligne sur la surface cible.

4. Luminaire selon l'une des revendications précédentes, **caractérisé en ce que** l'optique comprend un système optique secondaire (8) qui est séparé spatialement du module (1) et disposé dans un trajet lumineux de la lumière.

5. Luminaire selon la revendication 4, **caractérisé en ce que** le luminaire ne comporte aucune optique primaire.

6. Luminaire selon la revendication 4 ou 5, **caractérisé en ce que** l'optique secondaire (8) ne repose pas directement sur les LED.

7. Luminaire selon l'une des revendications 4 à 6, **caractérisé en ce que** l'optique secondaire (8) est réalisée sous la forme d'une couche polymère transparente sur un substrat transparent (10).

8. Luminaire selon l'une des revendications 4 à 7, **caractérisé en ce que** la lentille cylindrique (9) est formée sur l'optique secondaire (8).

9. Luminaire selon la revendication 8, **caractérisé en ce que** l'optique secondaire (8) comprend une pluralité de lentilles cylindriques (9) disposées côte à côte dans un plan.

10. Luminaire selon l'une des revendications précédentes, **caractérisé en ce qu'**un plan central (3a) de la rangée de LED (R) et un plan central optique (9a) parallèle à celui-ci d'une lentille cylindrique (9) regroupant la lumière de la rangée présentent un décalage (V2+V1) dans le sens transversal (W) l'un par rapport à l'autre.

11. Luminaire selon la revendication 10, **caractérisé en ce que** le décalage (V2+V1) par rapport à une lentille cylindrique associée pour différentes rangées de LEDS (R) est différent, notamment en fonction de la distance de la ligne à la rangée centrale de LEDS dans le sens transversal.

12. Luminaire selon l'une des revendications précédentes, **caractérisé en ce qu'**une densité de garnissage des LED est supérieure dans la direction longitudinale (L) que dans la direction transversale (W).

13. Luminaire selon la revendication 12, **caractérisé en ce que** la densité de garniture des LED dans la direction transversale (W) n'est pas supérieure à 60% de la densité de garniture des LED dans la direction longitudinale (L).

14. Luminaire selon l'une des revendications 1 à 12, **caractérisé en ce que** les LED sont disposées en grille,
dans laquelle les rangées (R) s'étendent dans la direction longitudinale (L) et les rangées (R) sont parallèles les unes aux autres dans la direction transversale (W),
dans laquelle les LED ont une première distance de répétition a dans la direction longitudinale (L), les LED ayant une distance de répétition b dans la direction transversale (W).

15. Luminaire selon la revendication 14, **caractérisée en ce que** la distance de répétition a est de 2 mm à 5 mm,
dans laquelle les LED ont une surface rayonnante d'environ 1 mm2.

16. Luminaire selon la revendication 14 ou 15, **caractérisée en ce que** la distance de répétition b est comprise entre 5 mm et 10 mm et est le double de la distance de répétition a.

17. Luminaire selon l'une des revendications précédentes, **caractérisé en ce que** le module (1) est conçu sous la forme d'un module chip-on-board intégré, dans lequel les LED (3) sont disposées sur un support plat.

18. Luminaire selon la revendication 17, **caractérisé en ce que** d'autres composants électroniques sont en outre disposés sur le support plat.

19. Luminaire selon l'une des revendications précédentes, **caractérisé en ce qu'**une pluralité de modules (1) et éventuellement une optique secondaire (8) sont disposés les uns derrière les autres dans la direction longitudinale (L).

20. Luminaire selon l'une des revendications précédentes, **caractérisé en ce que** le module (1) est disposé sur un radiateur.

21. Dispositif de séchage d'un revêtement, comprenant une lumière selon l'une des revendications précédentes, dans lequel un substrat plat avec le revêtement à sécher et la lumière sont mobiles l'un par rapport à l'autre dans une direction de transport, dans lequel la lumière s'étend dans une direction transversale au moins partiellement sur une largeur du substrat et est disposée à une distance définie au-dessus du substrat,
dans laquelle le dispositif est une machine à imprimer,
dans laquelle le substrat planaire est un produit imprimé,
dans laquelle le revêtement à sécher est une laque imprimée.

22. Utilisation d'une luminaire selon l'une quelconque des revendications 1 à 20 pour le séchage d'un revêtement, en particulier dans un procédé d'impression, le séchage du revêtement étant un séchage UV d'un vernis ou d'une encre dans une machine à imprimer.

23. Utilisation selon la revendication 22, **caractérisée en ce que** la machine d'impression est une machine d'impression offset pour sols.
